# FASCICULE DE BREVET EUROPEEN

(11) **EP 3 598 487 B1**
(45) Date de publication et mention de la délivrance du brevet: **27.01.2021**
(21) Numéro de dépôt: 19186225.9
(22) Date de dépôt: 15.07.2019
(51) Int. Cl.: H01L 23/31, H01L 21/56, B01L 3/00

(54) **PROCÉDÉ D'INTÉGRATION DE STRUCTURES DANS UN SUPPORT ET DISPOSITIF ASSOCIÉ**
INTEGRATIONSVERFAHREN VON STRUKTUREN IN EINE HALTERUNG, UND ENTSPRECHENDE VORRICHTUNG
METHOD FOR INTEGRATING STRUCTURES IN A SUPPORT AND ASSOCIATED DEVICE

(30) Priorité: 18.07.2018 FR 1856660
(43) Date de publication de la demande: 22.01.2020
(73) Titulaire: Commissariat à l'énergie atomique et aux énergies alternatives, 75015 Paris (FR)
(72) Inventeur: SOURIAU, Jean-Charles, 38054 GRENOBLE CEDEX 09 (FR); CONSTANTIN, Olivier, 38054 GRENOBLE CEDEX 09 (FR)
(74) Mandataire: Brevalex

(56) Documents cités:
- JP-A- H 088 463
- JP-A- 2005 174 979
- US-A1- 2003 064 506
- US-A1- 2008 032 425
- US-A1- 2010 013 060

## Description

### DOMAINE TECHNIQUE

La présente invention concerne un procédé d'intégration de structures dans des cavités traversantes d'un support. En particulier, l'invention concerne l'intégration de puces destinées à effectuer des analyses chimiques et/ou biologiques, dans des veines fluidiques.

### ÉTAT DE LA TECHNIQUE ANTÉRIEURE

Un procédé d'intégration de structures dans un support, connu de l'état de la technique, est décrit dans les documents [1],[2],[3] et [4] cités à la fin de la description.

Le procédé d'intégration comprend notamment les étapes suivantes :
a) fournir un support pourvu de deux faces principales dites, respectivement, face avant et face arrière, le support comprenant des cavités traversantes chacune délimitée par une paroi dite paroi traversante ;
b) insérer dans chacune des cavités traversantes au moins une structure, l'au moins une structure étant pourvue de deux faces, dites respectivement, première face et seconde face et reliées par un contour, l'insertion de l'au moins une structure étant exécutée de sorte que la première face et la face avant soient coplanaires, les cavités traversantes et/ou les structures étant agencées pour laisser un espace périphérique et traversant autour desdites structures, ledit espace périphérique étant délimité par la paroi traversante et le contour ;
c) remplir l'espace périphérique d'un matériau de scellement de manière à maintenir les structures au support.

À l'issue de l'étape c), un capot peut être disposé en recouvrement de la première face de chacune des structures. Ce capot peut notamment comprendre des canaux d'entrée et de sortie de fluide, et forme, avec la première face, une veine fluidique. Les canaux d'entrée et de sortie de fluide sont agencés pour faire circuler un ou plusieurs fluides destinés à une analyse au niveau de la première face de la structure.

À cet égard, les structures peuvent comprendre, au niveau de leur première face, des capteurs, notamment des capteurs biologiques par exemple destinées au séquençage de l'ADN, ou encore des capteurs chimiques.

Par ailleurs, afin d'assurer un écoulement de fluide couvrant l'intégralité de la première face, le capot présente généralement une étendue supérieure à ladite première face. Plus particulièrement, le capot est également en recouvrement, au niveau de la face avant, de l'espace périphérique.

De cet agencement résulte une exposition du matériau de scellement aux fluides susceptibles de circuler dans la veine fluidique.

Ce procédé connu de l'état de la technique n'est donc pas satisfaisant.

En effet, cette exposition du matériau de scellement peut conduire à des interactions avec lesdits fluides, et ainsi perturber leur analyse.

Par ailleurs, une diminution de la longueur d'extension radiale afin de réduire la surface d'interaction entre le fluide et le matériau de scellement ne peut être envisagée. En effet, le matériau de scellement présente généralement une viscosité importante, et une longueur d'extension radiale minimale est requise afin de permettre l'écoulement dudit matériau dans l'espace périphérique lors de l'étape c).

Un but de la présente invention est alors de proposer un dispositif pourvu de structures intégrées à un support ainsi qu'un procédé d'intégration de telles structures permettant de limiter les interactions entre le matériau de scellement et le fluide à analyser.

Un autre but de la présente invention est de limiter la topologie de la surface formée par le matériau de scellement entre les surfaces, en limitant le rétreint qui se produit pendant le durcissement du matériau de scellement.

Un autre but de la présente invention est également de proposer un procédé d'intégration de structures permettant de conserver la coplanarité de la première face des structures avec la face avant du support.

### EXPOSÉ DE L'INVENTION

Les buts de l'invention sont, au moins en partie, atteints par un procédé d'intégration de structures dans un support, le procédé comprenant les étapes suivantes :
a) fournir un support pourvu de deux faces principales dites, respectivement, face avant et face arrière, le support comprenant des cavités traversantes délimitées chacune par une paroi dite paroi traversante ;
b) insérer dans chacune des cavités traversantes au moins une structure, l'au moins une structure étant pourvue de deux faces, dites respectivement, première face et seconde face reliées par un contour, l'insertion de l'au moins une structure étant exécutée de sorte que la première face et la face avant soient coplanaires, les cavités traversantes et/ou les structures étant agencées pour laisser, autour de chacune des structures, un espace périphérique et traversant délimité par la paroi traversante et le contour ;
c) remplir l'espace périphérique d'un matériau de scellement de manière à maintenir les structures au support ;
le procédé étant remarquable en ce que l'espace périphérique présente une longueur d'extension radiale qui diminue de la face arrière vers la face avant.

Selon un mode de mise en œuvre, le matériau de scellement comprend un premier matériau de scellement et un second matériau de scellement, l'étape c) comprend le remplissage par le premier matériau de scellement d'une section, dite première section, de l'espace périphérique, puis par le second matériau de scellement différent du premier matériau de scellement, d'une autre section, dite seconde section, de l'espace périphérique.

Selon un mode de mise en œuvre, la première section est une section de l'espace périphérique pour laquelle la longueur d'extension radiale est inférieure à une longueur prédéterminée, et la seconde section est une section de l'espace périphérique pour laquelle la longueur d'extension radiale est supérieure à une longueur prédéterminée.

Selon un mode de mise en œuvre, pour chacun des espaces périphériques, une couche comprenant le premier matériau de scellement est également formée sur la paroi traversante et le contour au niveau de la seconde section.

Selon un mode de mise en œuvre, le premier matériau de scellement comprend au moins un des matériaux choisi parmi : colle époxy chargé ou non en grains de silice, du polyuréthane, de l'élastomère, du silicone, de l'acrylique, du méthacrylate, du polypropylène, du parylène, un siloxane, du verre ou du métal.

Selon un mode de mise en œuvre, le second matériau de scellement comprend au moins un des matériaux choisi parmi : colle époxy chargée en grains de silice, du polyuréthane, de l'élastomère, du silicone, de l'acrylique, du méthacrylate, du polypropylène ou du verre fusible.

Selon un mode de mise en œuvre, la longueur d'extension radiale varie de manière continue de la face arrière vers la face avant, avantageusement pour chacun des espaces périphériques, la paroi traversante présente une inclinaison convergente de la face arrière vers la face avant et/ou le contour présente une inclinaison divergente de la face arrière vers la face avant.

Selon un mode de mise en œuvre, la longueur d'extension radiale au niveau de la première section est inférieure à 50 % de la longueur d'extension radiale au niveau de la face arrière.

Selon un mode de mise en œuvre, la première section présente une longueur d'extension radiale constante, dite première longueur, la première longueur étant avantageusement inférieure à 25%, préférentiellement inférieure à 10%, à la longueur d'extension radiale au niveau de la face arrière.

Selon un mode de mise en œuvre, la seconde section présente une longueur d'extension radiale constante, dite seconde longueur.

Selon un mode de mise en œuvre, pour chacune des cavités traversantes, la paroi traversante présente un épaulement.

Selon un mode de mise en œuvre, le contour de chacune des structures présente un épaulement.

Selon un mode de mise en œuvre, la seconde section s'étend, à partir de la face arrière, sur une profondeur correspondant à au moins la moitié de l'épaisseur du support.

Selon un mode de mise en œuvre, la longueur d'extension radiale au niveau de la face avant est comprise entre 5 µm et 100 µm.

Selon un mode de mise en œuvre, la structure comprend, sur sa première face, au moins un site réactionnel ou un capteur, le site réactionnel et le capteur étant avantageusement destinés à des applications biologiques ou chimiques.

Selon un mode de mise en œuvre, la structure comprend, sur sa première face un actuateur, l'actuateur étant avantageusement destiné à émettre un rayonnement d'une longueur d'onde prédéterminé.

Selon un mode de mise en œuvre, le premier matériau est choisi de sorte à ne pas adsorber les espèces chimiques ou biologiques destinées à interagir avec le site réactionnel ou le capteur.

Selon un mode de mise en œuvre, le premier matériau choisi présente un niveau de fluorescence à la longueur d'onde prédéterminée inférieur à une valeur donnée.

Selon un mode de mise en œuvre, le second matériau de scellement présente un module d'Young compris dans un intervalle à +/- 20%, avantageusement +/-15%, du module d'Young du support.

Selon un mode de mise en œuvre, chaque structure comprend une première structure et une seconde structure présentant chacune une face coplanaire avec la face avant.

Selon un mode de mise en œuvre, l'étape b) est précédée d'une étape d'assemblage a1) de la face avant du support avec une face temporaire d'un substrat temporaire.

Selon un mode de mise en œuvre, l'étape a1) est exécutée au moyen d'une couche d'adhésion formée sur la face temporaire du substrat temporaire, la couche d'adhésion comprend en particulier au moins un des matériaux choisi parmi : une résine, un film adhésif laminé, un polymère photosensible.

Selon un mode de mise en œuvre, l'étape c) est suivie d'une étape d) de démontage du substrat temporaire correspondant au retrait de ce dernier.

Selon un mode de mise en œuvre, les cavités traversantes sont formées par gravure sèche ou par gravure humide.

L'invention concerne également un dispositif susceptible d'être obtenu par le procédé selon la présente invention, le dispositif comprenant :
a) un support pourvu de deux faces principales dites, respectivement, face avant et face arrière, le support comprenant une cavité traversante délimitée par une paroi dite paroi traversante ;
b) au moins une structure, l'au moins une structure étant pourvue de deux faces, dites respectivement, première face et seconde face reliées par un contour (230), l'au moins une structure étant logée dans la cavité traversante et de sorte que la première face et la face avant soient coplanaires, la cavité traversante et/ou l'au moins une structure étant agencées pour laisser, autour de la structure, un espace périphérique et traversant délimité par la paroi traversante et le contour ;
l'espace périphérique étant rempli d'un matériau de scellement de manière à maintenir les structures au support ;
le dispositif étant remarquable en ce que l'espace périphérique présente une longueur d'extension radiale qui diminue de la face arrière vers la face avant.

Selon un mode de mise en œuvre, le matériau de scellement comprend un premier matériau de scellement et un second matériau de scellement, le premier matériau de scellement comblant une section, dite première section, de l'espace périphérique, et le second matériau de scellement différent du premier matériau de scellement, comblant une autre section, dite seconde section, de l'espace périphérique.

Selon un mode de mise en œuvre, la première section est une section de l'espace périphérique pour laquelle la longueur d'extension radiale est inférieure à une longueur prédéterminée, et la seconde section est une section de l'espace périphérique pour laquelle la longueur d'extension radiale est supérieure à une longueur prédéterminée.

Selon un mode de mise en œuvre, une couche comprenant le premier matériau de scellement est également formée sur la paroi traversante et le contour au niveau de la seconde section.

Selon un mode de mise en œuvre, le premier matériau de scellement comprend au moins un des matériaux choisi parmi : colle époxy chargé ou non en grains de silice, du polyuréthane, de l'élastomère, du silicone, de l'acrylique, du méthacrylate, du polypropylène, du parylène, du siloxane, du verre ou du métal.

Selon un mode de mise en œuvre, le second matériau de scellement comprend au moins un des matériaux choisi parmi : colle époxy chargée en grains de silice, du polyuréthane, de l'élastomère, du silicone, de l'acrylique, du méthacrylate, du polypropylène ou du verre fusible.

Selon un mode de mise en œuvre, la longueur d'extension radiale varie de manière continue de la face arrière vers la face avant, avantageusement la paroi traversante présente une inclinaison convergente de la face arrière vers la face avant et/ou le contour présente une inclinaison divergente de la face arrière vers la face avant.

Selon un mode de mise en œuvre, la longueur d'extension radiale au niveau de la première section est inférieure à 50 % de la longueur d'extension radiale au niveau de la face arrière.

Selon un mode de mise en œuvre, la première section présente une longueur d'extension radiale constante, dite première longueur, la première longueur étant avantageusement inférieure à 25%, préférentiellement inférieure à 10%, à la longueur d'extension radiale au niveau de la face arrière.

Selon un mode de mise en œuvre, la seconde section présente une longueur d'extension radiale constante, dite second longueur.

Selon un mode de mise en œuvre, la paroi traversante présente un épaulement.

Selon un mode de mise en œuvre, le contour présente un épaulement.

Selon un mode de mise en œuvre, la seconde section s'étend, à partir de la face arrière, sur une profondeur correspondant à au moins la moitié de l'épaisseur du support.

Selon un mode de mise en œuvre, la longueur d'extension radiale au niveau de la face avant est comprise entre 5 µm et 100 µm.

Selon un mode de mise en œuvre, le second matériau de scellement présente un module d'Young compris dans un intervalle à +/- 20%, avantageusement +/-15%, du module d'Young du support.

Selon un mode de mise en œuvre, la structure comprend une première structure et une seconde structure présentant chacune une face coplanaire avec la face avant du support.

### BRÈVE DESCRIPTION DES DESSINS

D'autres caractéristiques et avantages apparaîtront dans la description qui va suivre du procédé d'intégration de structures selon l'invention, donnés à titre d'exemples non limitatifs, en référence aux dessins annexés dans lesquels :
- les figures la à 1f sont des représentations schématiques des différentes étapes du procédé d'intégration de structures selon la présente invention ;
- la figure 2 est une représentation schématique selon un plan de coupe du support selon une direction orthogonale à ses faces principales d'un premier exemple de mise en œuvre de la présente invention, la figure 2 représente notamment une structure insérée dans une cavité traversante ;
- les figures 3a et 3b sont des représentations schématiques selon un plan de coupe du support selon une direction orthogonale à ses faces principales d'un second exemple de mise en œuvre de la présente invention, les figures 3a et 3b représentent notamment une structure insérée dans une cavité traversante.

### EXPOSÉ DÉTAILLÉ DE MODES DE RÉALISATION PARTICULIERS

La présente invention concerne un procédé d'intégration de structures dans un support, et notamment du scellement, avec un matériau de scellement, desdites structures dans des cavités traversantes formées dans le support.

Le scellement des structures implique en particulier une mise en forme d'un espace de scellement, dit espace périphérique, ménagé entre le contour des structures et la paroi délimitant les cavités traversantes. Notamment, l'espace périphérique selon l'invention présente une longueur d'extension radiale qui diminue de la face arrière vers la face avant du support de manière à limiter l'exposition du matériau de scellement au niveau de la face avant du support.

Ainsi, aux figures la-lf, 2, 3a et 3b, on peut voir des exemples de mise en œuvre du procédé d'intégration de structures dans un support.

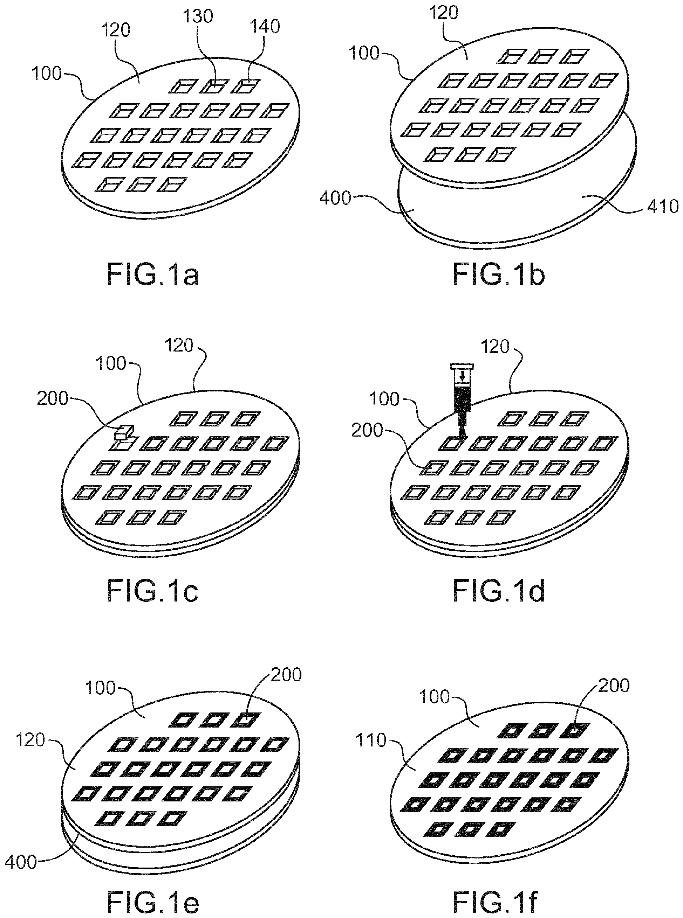

En particulier le procédé selon la présente invention comprend les étapes suivantes :
a) fournir un support 100 pourvu de deux faces principales dites, respectivement, face avant 110 et face arrière 120. Le support 100 comprend notamment des cavités traversantes 130 délimitées chacune par une paroi dite paroi traversante 140 (figure la).
b) insérer dans chacune des cavités traversantes 140 au moins une structure 200. L'au moins une structure 200 est, à cet égard, pourvue de deux faces, dites respectivement, première face 210 et seconde face 220, reliées par un contour 230. L'insertion de l'au moins une structure 200 est exécutée de sorte que la première face 210 et la face avant 110 soient coplanaires. Par ailleurs, les cavités traversantes 130 et/ou les structures 200 sont agencées pour laisser, autour de chacune des structures, un espace périphérique 300 et traversant délimité par la paroi traversante 140 et le contour 230 (figures 1c, 2, 3a et 3b).
c) remplir l'espace périphérique 300 d'un matériau de scellement de manière à maintenir les structures 200 au support 100 (figure 1d).

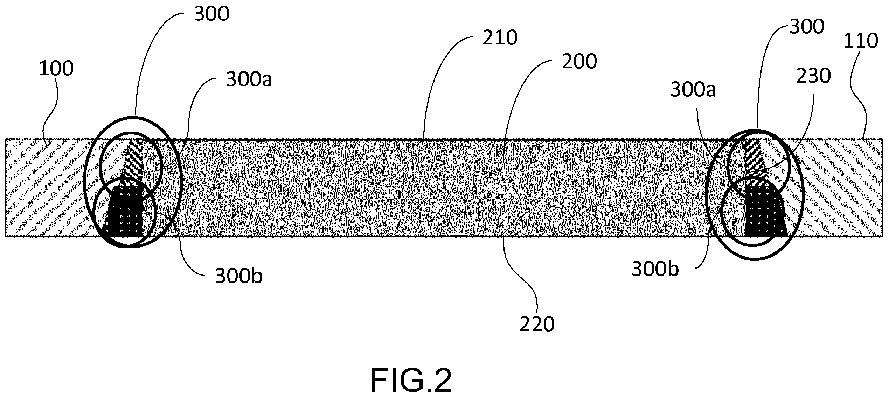

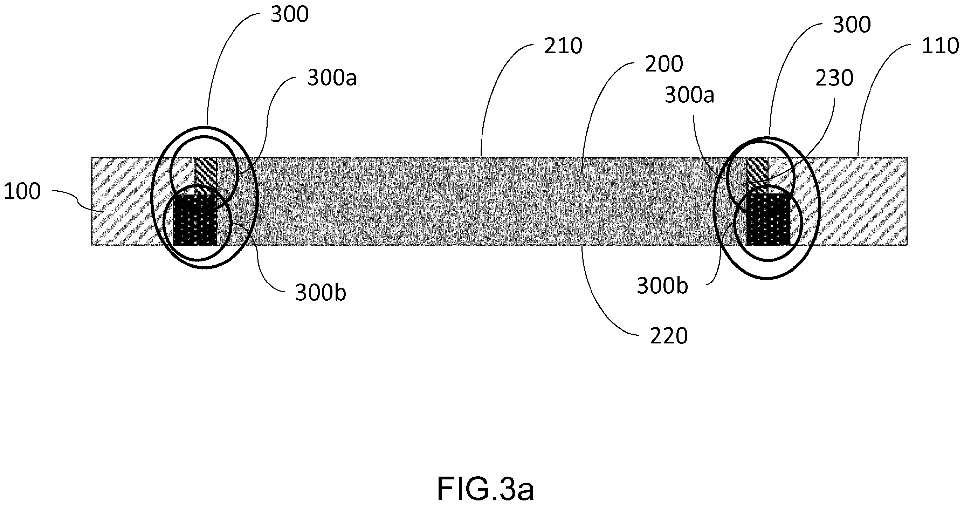

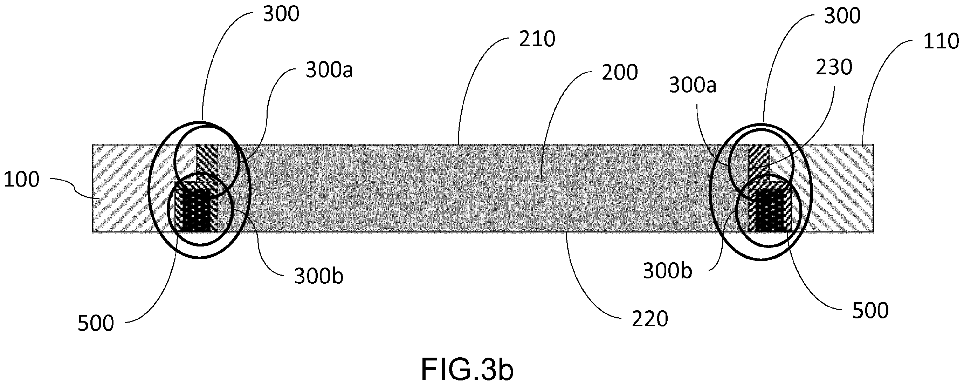

Selon la présente invention, l'espace périphérique 300 présente une longueur d'extension radiale qui diminue de la face arrière 120 vers la face avant 110 (figures 2, 3a et 3b).

En d'autres termes, un rétrécissement de l'espace périphérique 300 est observé de la face arrière 120 vers la face avant 110 (figures 2, 3a et 3b).

Par « longueur d'extension radiale », on entend la distance entre la paroi traversante 140 et le contour 230 délimitant l'espace périphérique.

Par ailleurs, il est entendu que, pour chaque cavité traversante 130, l'espace périphérique 300 contourne la structure, logée dans la dite cavité, dans son entièreté.

Le support 100 fourni à l'étape a) peut comprendre tout type de matériaux, et notamment comprendre au moins un des matériaux choisis parmi : du silicium, du verre, du polymère ou du plastique, du nitrure d'aluminium ou une céramique.

Le support 100 peut également comprendre un circuit imprimé (« Printed Circuit Board » ou « PCB » selon la terminologie anglo-saxonne).

Le support 100 peut également comprendre une couche de passivation. Par exemple, la couche de passivation d'un support en silicium peut comprendre de l'oxyde de silicium, déposé ou obtenu par oxydation thermique, ou encore du nitrure de silicium.

Par « cavité traversante », on entend une cavité débouchant sur l'une et l'autre des faces avant 110 et arrière 120 du support 100.

Les cavités traversantes 130 peuvent être formées par des techniques de micro fabrication connues de l'homme du métier, et peuvent plus particulièrement impliquer des étapes de photo lithographie, de formation de masque dur, et de gravure liquide ou sèche.

Les cavités traversantes 130 peuvent, de manière alternative être formées par des techniques de sablage, d'usinage laser ou mécanique. Ces techniques soustractives sont avantageusement mises en œuvre dans du silicium, du verre ou un polymère.

De manière alternative, le support 100 pourvu de la cavité traversante 130 peut être fabriqué par fabrication additive (impression 3D, injection), par exemple lorsqu'un polymère est considéré.

Le support 100 peut également présenter une épaisseur comprise entre 200 µm et 1000 µm, avantageusement entre 300 µm et 800 µm, en particulier égale à 725 µm.

L'étape b) comprend l'insertion de structures 200 dans les cavités traversantes 130.

L'insertion des structures 200 dans lesdites cavités est notamment adaptée pour, qu'à l'issue de l'étape b), la première face 210 des structures 200 soit coplanaire avec la face avant 110.

L'alignement des structures 200 dans les cavités traversantes peut notamment faire intervenir des motifs d'alignement formés sur la face arrière 120 ou sur une face temporaire 410 d'un substrat temporaire 400 qui sera décrit dans la suite de la description.

Cet agencement est particulièrement avantageux, notamment dans le cadre d'applications fluidiques ou micro fluidiques, puisqu'il permet de limiter les perturbations d'un écoulement fluidique au niveau de la première face 210. Il peut également permettre de limiter l'interaction du matériau de scellement avec les fluides ou des espèces d'intérêt véhiculées par les fluides (par exemple adsorption de protéines). Cet agencement peut aussi limiter ou supprimer la topologie pouvant advenir lors du durcissement du matériau de scellement.

L'étape b) peut être précédée d'une étape d'assemblage de la face avant 110 du support 100 avec une face, dite face temporaire 410, d'un substrat temporaire 400 (figure 1b).

Il est entendu que cet assemblage est temporaire, et que l'adhésion entre la face temporaire 410, la face avant 110 et la première face 210, ainsi que la surface en contact du matériau de scellement, est détachable.

À cet égard, l'assemblage peut être obtenu par adhésion moléculaire, ou par l'intermédiaire d'une couche d'adhésion formée sur la face temporaire 410.

La couche d'adhésion peut notamment comprendre une résine, un film adhésif laminé, un polymère photosensible.

Le substrat temporaire 400 peut comprendre au moins un des matériaux choisi parmi : silicium, verre, quartz, alumine, plastique.

De manière alternative, le substrat temporaire 400, au sens de la présente invention, peut être un film adhésif.

La mise en œuvre du substrat temporaire 400 permet, lors de l'insertion des structures 200 dans les cavités traversantes 130, d'assurer la coplanarité des premières faces 210 avec la face avant 110.

Toutefois, l'invention ne doit pas être limitée à la mise en œuvre d'une étape d'assemblage avec le substrat temporaire.

L'étape b) est alors suivie de l'étape c) de scellement des structures 200 au support 100. L'étape c) comprend notamment le remplissage de l'espace périphérique 300 par le matériau de scellement de manière à maintenir les structures 200 au support 100.

Le remplissage peut avantageusement comprendre une étape d'injection du matériau de scellement.

Le remplissage peut être exécuté en une ou plusieurs étapes.

Par exemple, le matériau de scellement peut comprendre un premier matériau de scellement et un second matériau de scellement.

En particulier, le premier matériau de scellement peut remplir la section la plus étroite, nommée ci-après première section 300a, de l'espace périphérique 300.

De manière équivalente, le second matériau de scellement peut remplir la section la plus large, nommée ci-après seconde section 300b, de l'espace périphérique 300.

De manière particulièrement avantageuse, le premier matériau de scellement présente une viscosité inférieure à la viscosité du second matériau de scellement.

Le remplissage de l'espace périphérique par le matériau de scellement peut n'être que partiel. Par exemple, seule la première section 300a peut être remplie par le matériau de remplissage. Toujours à titre d'exemple, le remplissage de l'espace périphérique 300 par le matériau de remplissage peut être inférieur à 50%, ou encore inférieur à 30%.

La première section 300a est une section de l'espace périphérique pour laquelle la longueur d'extension radiale est inférieure à une longueur prédéterminée, et la seconde section est une section de l'espace périphérique 300 pour laquelle la longueur d'extension radiale est supérieure à ladite longueur prédéterminée.

La longueur prédéterminée est dépendante de la nature du second matériau de scellement, et notamment de sa viscosité. Plus particulièrement, plus la viscosité du second matériau de scellement est élevée plus l'espace nécessaire à l'écoulement du second matériau est important, et par voie de conséquence plus la longueur prédéterminée est importante.

Par exemple, la seconde section peut s'étendre, à partir de la face arrière 120, sur une profondeur correspondant à au moins la moitié de l'épaisseur du support 100.

La longueur d'extension radiale au niveau de la face avant 110 peut être comprise entre 5 µm et 100 µm.

Le remplissage de la première section par le premier matériau de scellement peut être exécuté à l'aide d'une seringue, par jet de matière, par laminage sous vide ou encore par dépôt chimique en phase vapeur de parylène.

Le remplissage de la seconde section par le premier ou le deuxième matériau de scellement peut être exécuté à l'aide d'une seringue, par jet de matière, par laminage sous vide, par injection ou encore par moulage.

Lors de l'exécution de l'étape c), pour chacun des espaces périphériques, une couche 500 comprenant le premier matériau de scellement peut également être formée sur la paroi traversante 140 et le contour 230 au niveau de la seconde section 300b (figure 3c). La couche peut notamment présenter une épaisseur inférieure à 10 µm.

De manière avantageuse, le premier matériau de scellement comprend au moins un des matériaux choisi parmi : colle époxy chargé ou non en grains de silice, du polyuréthane, du parylène, un siloxane, de l'élastomère, du silicone, de l'acrylique, du méthacrylate, du polypropylène, du verre ou du métal. Ces matériaux peuvent être judicieusement choisis pour leur faible réactivité chimique ou leur faible fluorescence.

Toujours de manière avantageuse, le second matériau de scellement peut comprendre au moins une des familles de matériaux choisie parmi : colle époxy chargée en grains de silice, du polyuréthane, de l'élastomère, du silicone, de l'acrylique, du méthacrylate, du polypropylène et du verre fusible.

Le second matériau de scellement peut présenter un module d'Young compris dans un intervalle de +/- 20%, avantageusement +/- 15 %, autour du module d'Young du support 100.

Le second matériau de scellement peut présenter un coefficient d'expansion thermique (« CTE ») compris dans un intervalle de +/- 20%, avantageusement +/-15 %, autour du CTE du support 100.

L'étape de remplissage de l'espace périphérique par le matériau de scellement peut avantageusement être suivie d'une étape, dite de durcissement, destinée à faire sécher ledit matériau. L'étape de durcissement peut par exemple impliquer un traitement thermique.

Si la mise en œuvre du substrat temporaire 400 est considérée, l'étape c) est alors suivie d'une étape de démontage dudit substrat 400 (figures le et 1f).

Le démontage du substrat temporaire 400 dépendra du type d'assemblage entre la face avant 110 et la face temporaire 410.

En particulier, le démontage peut impliquer une contrainte mécanique ou thermique, un pelage, une gravure chimique ou encore une étape d'insolation de la couche d'adhésion.

La configuration de l'espace périphérique 300, et notamment son rétrécissement, permet de limiter l'exposition du matériau de scellement au niveau de la face avant, notamment l'exposition aux fluides dans le domaine des applications fluidiques.

Par ailleurs, l'ouverture plus importante de l'espace périphérique 300 au niveau de la face arrière 120 permet de considérer un matériau de scellement présentant une viscosité importante.

Selon un premier exemple de mise œuvre illustré à la figure 2, la longueur d'extension radiale peut varier de manière continue, et notamment linéairement, de la face arrière 120 vers la face avant 110.

Notamment, selon ce premier exemple, la paroi traversante 140 peut présenter une inclinaison convergente de la face arrière vers la face avant et/ou le contour peut présenter une inclinaison divergente de la face arrière vers la face avant.

Par « inclinaison convergente de la face arrière vers la face avant », on entend par exemple un tronc de cône ou de pyramide.

Par « inclinaison divergente de la face arrière vers la face avant », on entend un tronc de cône ou de pyramide inversé.

Une paroi traversante 140 présentant une inclinaison convergente peut par exemple être obtenue en formant les cavités traversantes par gravure chimique en phase liquide, par exemple avec une solution de TMAH ou de KOH.

En particulier, selon ce premier exemple, la longueur d'extension radiale au niveau de la première section 300a est inférieure à 50 % de la longueur d'extension radial au niveau de la face arrière 120.

Selon un second exemple de mise en œuvre, la première section 300a présente une longueur d'extension radiale constante, dite première longueur (figures 3a et 3b).

En particulier, la première longueur peut avantageusement être inférieure à 25%, préférentiellement inférieure à 10%, à la longueur d'extension radiale au niveau de la face arrière 120.

De manière complémentaire, la seconde section 300b présente une longueur d'extension radiale constante, dite seconde longueur, supérieure à la première longueur.

Cette configuration peut par exemple être traduite par la présence d'un épaulement au niveau de la paroi traversante 140.

De manière complémentaire ou alternative, le contour de chacune des structures présente un épaulement.

L'invention n'est toutefois pas limitée à ces deux exemples de réalisation. Notamment seule une section parmi la première section 300a et la seconde section 300b peut présenter une longueur d'extension radiale constante, tandis que l'autre section présente une longueur d'extension variable.

Toujours dans le cadre de la présente invention, l'un et/ou l'autre du contour 230 et de la paroi traversante 140 peut présenter une pluralité d'épaulements.

La structure 200 peut comprendre, sur sa première face 210, un capteur.

Le capteur peut être par exemple un capteur destiné à exécuter des analyses chimiques d'un fluide circulant au niveau de la première face 210.

De manière alternative, le capteur peut être un capteur biologique, par exemple appliqué au séquençage des gènes.

De manière avantageuse, le premier matériau peut être choisi de manière à ne pas adsorber les espèces chimiques ou biologiques destinées à interagir avec le capteur.

De manière alternative ou complémentaire, la structure 200 peut comprendre, sur sa première face au moins un site réactionnel, par exemple un site réactionnel destiné à exécuter des analyses biologiques ou chimiques d'un fluide circulant au niveau de la première face 210.

De manière avantageuse, le premier matériau peut être choisi de manière à ne pas adsorber les espèces chimiques ou biologiques destinées à interagir avec le site réactionnel.

Toujours de manière alternative ou complémentaire, la structure 200 peut comprendre, sur sa première face 210, un actuateur, et notamment un actuateur destiné à émettre un rayonnement d'une longueur d'onde prédéterminé. La longueur d'onde prédéterminée est par exemple une longueur d'onde comprise entre 400 nm et 780 nm.

Le premier matériau choisi peut alors présenter un niveau de fluorescence à la longueur d'onde prédéterminée inférieur à une valeur donnée.

Quel que soit le mode de réalisation considéré le premier matériau choisi est inerte vis-à-vis de l'application visée.

Par « inerte », on entend un premier matériau qui interagira de manière limitée avec un fluide circulant au niveau de la première face du capteur ou avec des espèces d'intérêt circulant dans ledit fluide.

Pour des applications dans le domaine de la biologie, et notamment le séquençage de l'ADN, un premier matériau non fluorescent sera particulièrement avantageux.

Toujours à titre d'exemple, pour des applications dans le domaine de la chimie, le premier matériau sera choisi de manière à ne pas réagir chimiquement avec les fluides destinés à être analysés par le capteur.

De manière complémentaire, chaque structure peut comprendre une première structure et une seconde structure présentant chacune une face coplanaire avec la face avant. Par exemple, la première structure peut comprendre un imager CMOS et la seconde structure une source d'excitation lumineuse du type VCSEL.

À l'issu du procédé selon la présente invention, un capot peut être disposé en recouvrement de la première face de chacune des structures. Ce capot peut notamment comprendre des canaux d'entrée et de sortie de fluide, et forme, avec la première face, une veine fluidique. Les canaux d'entrée et de sortie de fluide sont agencés pour faire circuler un ou plusieurs fluides destinés à être analysés au niveau de la première face de la structure.

La présente invention est avantageusement mise en œuvre pour des applications micro fluidiques destinées à l'analyse chimique, biochimique, ou encore biologique de fluides.

### RÉFÉRENCES CITEES

[1] WO 2008/155231
[2] FR 2934082
[3] JP H088463 A
[4] US 2003/064506 A1

## Revendications

1. Procédé d'intégration de structures (200) dans un support (100), le procédé comprenant les étapes suivantes :
a) fournir un support (100) pourvu de deux faces principales dites, respectivement, face avant (110) et face arrière (120), le support (100) comprenant des cavités traversantes (130) délimitées chacune par une paroi dite paroi traversante (140) ;
b) insérer dans chacune des cavités traversantes (130) au moins une structure (200), l'au moins une structure (200) étant pourvue de deux faces, dites respectivement, première face (210) et seconde face (220) reliées par un contour (230), l'insertion de l'au moins une structure (200) étant exécutée de sorte que la première face (210) et la face avant (110) soient coplanaires, les cavités traversantes (130) et/ou les structures (200) étant agencées pour laisser, autour de chacune des structures (200), un espace périphérique (300) et traversant délimité par la paroi traversante (140) et le contour(230) ;
c) remplir l'espace périphérique (300) d'un matériau de scellement de manière à maintenir les structures (200) au support (100) ;
le procédé étant **caractérisé en ce que** l'espace périphérique (300) présente une longueur d'extension radiale qui diminue de la face arrière (120) vers la face avant (110) et **en ce que** le matériau de scellement comprend un premier matériau de scellement et un second matériau de scellement différent du premier matériau de scellement, l'étape c) comprend le remplissage par le premier matériau de scellement d'une section, dite première section (300a), de l'espace périphérique (300), puis par le second matériau de scellement d'une autre section, dite seconde section (300b), de l'espace périphérique (300).

2. Procédé selon la revendication 1, dans lequel, pour chacun des espaces périphériques (300), une couche (500) comprenant le premier matériau de scellement est également formée sur la paroi traversante (140) et le contour (230) au niveau de la seconde section (300b).

3. Procédé selon la revendication 1 ou 2, dans lequel le premier matériau de scellement comprend au moins un des matériaux choisi parmi : colle époxy chargé ou non en grains de silice, du polyuréthane, du parylène, un siloxane, de l'élastomère, du silicone, de l'acrylique, du méthacrylate, du polypropylène, du verre ou du métal.

4. Procédé selon l'une des revendications 1 à 3, dans lequel le second matériau de scellement comprend au moins un des matériaux choisi parmi : colle époxy chargée en grains de silice, du polyuréthane, de l'élastomère, du silicone, de l'acrylique, du méthacrylate, du polypropylène et du verre fusible.

5. Procédé selon l'une des revendications 1 à 4, dans lequel la longueur d'extension radiale varie de manière continue de la face arrière (120) vers la face avant (110), avantageusement pour chacun des espaces périphériques (300), la paroi traversante (140) présente une inclinaison convergente de la face arrière (120) vers la face avant (110) et/ou le contour (230) présente une inclinaison divergente de la face arrière (120) vers la face avant (110).

6. Procédé selon les revendications 1 et 5, dans lequel la longueur d'extension radiale au niveau de la première section (300a) est inférieure à 50 % de la longueur d'extension radial au niveau de la face arrière (120).

7. Procédé selon l'une des revendications 1 à 4, dans lequel la première section (300a) présente une longueur d'extension radiale constante, dite première longueur, la première longueur étant avantageusement inférieure à 25%, préférentiellement inférieure à 10%, à la longueur d'extension radiale au niveau de la face arrière (120).

8. Procédé selon l'une des revendications 1 à 7, dans lequel la seconde section (300b) s'étend, à partir de la face arrière (120), sur une profondeur correspondant à au moins la moitié de l'épaisseur du support (100).

9. Procédé selon l'une des revendications 1 à 8, dans lequel la longueur d'extension radiale au niveau de la face avant (110) est comprise entre 5 µm et 100 µm.

10. Procédé selon l'une des revendications 1 à 9, dans lequel le second matériau de scellement présente un module d'Young compris dans un intervalle à +/- 20%, avantageusement +/- 15%, du module d'Young du support (100).

11. Procédé selon l'une des revendications 1 à 10, dans lequel chaque structure (200) comprend une première structure (200) et une seconde structure (200) présentant chacune une face coplanaire avec la face avant (110).

12. Procédé selon l'une des revendications 1 à 11, dans lequel l'étape b) est précédée d'une étape d'assemblage a1) de la face avant (110) du support (100) avec une face temporaire (410) d'un substrat temporaire (400).

13. Dispositif comprenant :
a) un support (100) pourvu de deux faces principales dites, respectivement, face avant (110) et face arrière (120), le support (100) comprenant une cavité traversante (130) délimitée par une paroi dite paroi traversante (140) ;
b) au moins une structure (200), l'au moins une structure (200) étant pourvue de deux faces, dites respectivement, première face (210) et seconde face (220) reliées par un contour (230), l'au moins une structure étant logée dans la cavité traversante (130) et de sorte que la première face (210) et la face avant (110) soient coplanaires, la cavité traversante (130) et/ou l'au moins une structure (200) étant agencées pour laisser, autour de la structure (200), un espace périphérique (300) et traversant délimité par la paroi traversante (140) et le contour (230) ;
l'espace périphérique étant rempli d'un matériau de scellement de manière à maintenir les structures (200) au support (100) ;
le dispositif étant **caractérisé en ce que** l'espace périphérique (300) présente une longueur d'extension radiale qui diminue de la face arrière (120) vers la face avant (110), et **en ce que** le matériau de scellement comprend un premier matériau de scellement et un second matériau de scellement différent du premier matériau, le premier matériau de scellement comblant une section, dite première section (300a), de l'espace périphérique (300), et le second matériau de scellement comblant une autre section, dite seconde section (300b), de l'espace périphérique (300).

14. Dispositif selon la revendication 13, dans lequel une couche (500) comprenant le premier matériau de scellement est également formée sur la paroi traversante (140) et le contour (230) au niveau de la seconde section (300b).

15. Dispositif selon l'une des revendications 13 à 14, dans lequel la longueur d'extension radiale varie de manière continue de la face arrière (120) vers la face avant (110), avantageusement la paroi traversante (140) présente une inclinaison convergente de la face arrière (120) vers la face avant (110) et/ou le contour (230) présente une inclinaison divergente de la face arrière (120) vers la face avant (110).

16. Dispositif selon l'une des revendications 13 à 15, dans lequel la première section (300a) présente une longueur d'extension radiale constante, dite première longueur, la première longueur étant avantageusement inférieure à 25%, préférentiellement inférieure à 10%, à la longueur d'extension radiale au niveau de la face arrière (120).

17. Dispositif selon la revendication 16, dans lequel la seconde section (300b) présente une longueur d'extension radial constante, dite second longueur.

## Patentansprüche

1. Verfahren zum Integrieren von Strukturen (200) in einen Träger (100), wobei das Verfahren die folgenden Schritte umfasst:
a) Bereitstellen eines Trägers (100), der mit zwei Hauptflächen, Vorderseite (110) bzw. Rückseite (120) genannt, versehen ist, wobei der Träger (100) durchgehende Hohlräume (130) aufweist, die jeweils durch eine Wand (140), Durchgangswand (140) genannt, begrenzt sind;
b) Einsetzen zumindest einer Struktur (200) in jeden der durchgehenden Hohlräume (130), wobei die zumindest eine Struktur (200) mit zwei Flächen, als erste Fläche (210) und zweite Fläche (220) genannt, versehen ist, die über eine Kontur (230) verbunden sind, wobei das Einsetzen der zumindest einen Struktur (200) so erfolgt, dass die erste Fläche (210) und die Vorderseite (110) koplanar verlaufen, wobei die durchgehenden Hohlräume (130) und/oder die Strukturen (200) so angeordnet sind, dass sie um jede der Strukturen (200) herum einen Umfangs- und Durchgangsraum (300) belassen, der durch die Durchgangswand (140) und die Kontur (230) begrenzt ist;
c) Füllen des Umfangsraums (300) mit einem Dichtungsmaterial, um die Strukturen (200) am Träger (100) zu halten;
wobei das Verfahren **dadurch gekennzeichnet ist, dass** der Umfangsraum (300) eine radiale Erstreckungslänge aufweist, die von der Rückseite (120) zur Vorderseite (110) hin abnimmt, und dass das Dichtungsmaterial ein erstes Dichtungsmaterial und ein zweites Dichtungsmaterial enthält, das sich von dem ersten Dichtungsmaterial unterscheidet,
wobei Schritt c) das Füllen eines Abschnitts des Umfangsraums (300), erster Abschnitt (300a) genannt, mit dem ersten Dichtungsmaterials und dann das Füllen eines weiteren Abschnitts des Umfangsraums (300), zweiter Abschnitt (300b) genannt, mit dem zweiten Dichtungsmaterial umfasst.

2. Verfahren nach Anspruch 1, wobei für jeden der Umfangsräume (300) eine Schicht (500) aus dem ersten Dichtungsmaterial auch an der Durchgangswand (140) und der Kontur (230) im Bereich des zweiten Abschnitts (300b) gebildet wird.

3. Verfahren nach Anspruch 1 oder 2, wobei das erste Dichtungsmaterial zumindest eines der Materialien enthält, die ausgewählt sind aus: mit Kieselsäurekorn gefülltem oder ungefülltem Epoxidkleber, Polyurethan, Parylen, einem Siloxan, Elastomer, Silikon, Acryl, Methacrylat, Polypropylen, Glas oder Metall.

4. Verfahren nach einem der Ansprüche 1 bis 3, wobei das zweite Dichtungsmaterial zumindest eines der Materialien enthält, die ausgewählt sind aus: mit Kieselsäurekorn gefülltem Epoxidkleber, Polyurethan, Elastomer, Silikon, Acryl, Methacrylat, Polypropylen und schmelzbarem Glas.

5. Verfahren nach einem der Ansprüche 1 bis 4, wobei die radiale Erstreckungslänge von der Rückseite (120) zur Vorderseite (110) hin kontinuierlich variiert, vorteilhaft bei jedem der Umfangsräume (300) die Durchgangswand (140) von der Rückseite (120) zur Vorderseite (110) eine konvergierende Neigung aufweist und/oder die Kontur (230) von der Rückseite (120) zur Vorderseite (110) eine divergierende Neigung aufweist.

6. Verfahren nach einem der Ansprüche 1 und 5, wobei die radiale Erstreckungslänge im Bereich des ersten Abschnitts (300a) weniger als 50 % der radialen Erstreckungslänge im Bereich der Rückseite (120) beträgt.

7. Verfahren nach einem der Ansprüche 1 bis 4, wobei der erste Abschnitt (300a) eine konstante radiale Erstreckungslänge, erste Länge genannt, aufweist, wobei die erste Länge vorteilhaft weniger als 25 %, vorzugsweise weniger als 10 %, der radialen Erstreckungslänge im Bereich der Rückseite (120) beträgt.

8. Verfahren nach einem der Ansprüche 1 bis 7, wobei sich der zweite Abschnitt (300b) ausgehend von der Rückseite (120) über eine Tiefe erstreckt, die zumindest der halben Dicke des Trägers (100) entspricht.

9. Verfahren nach einem der Ansprüche 1 bis 8, wobei die radiale Erstreckungslänge im Bereich der Vorderseite (110) zwischen 5 µm und 100 µm beträgt.

10. Verfahren nach einem der Ansprüche 1 bis 9, wobei das zweite Dichtungsmaterial einen Elastizitätsmodul im Bereich von +/- 20%, vorzugsweise +/- 15%, des Elastizitätsmoduls des Trägers (100) aufweist.

11. Verfahren nach einem der Ansprüche 1 bis 10, wobei jede Struktur (200) eine erste Struktur (200) und eine zweite Struktur (200) enthält, die jeweils eine Fläche aufweisen, die koplanar mit der Vorderseite (110) ist.

12. Verfahren nach einem der Ansprüche 1 bis 11, wobei dem Schritt b) ein Schritt des Zusammenfügens a1) der Vorderseite (110) des Trägers (100) mit einer vorläufigen Fläche (410) eines vorläufigen Substrats (400) vorausgeht.

13. Vorrichtung, enthaltend:
a) einen Träger (100), der mit zwei Hauptflächen versehen ist, Vorderseite (110) bzw. Rückseite (120) genannt, wobei der Träger (100) einen durchgehenden Hohlraum (130) aufweist, der durch eine Wand, Durchgangswand (140) genannt, begrenzt ist;
b) zumindest eine Struktur (200), wobei die zumindest eine Struktur (200) mit zwei Flächen versehen ist, erste Fläche (210) bzw. zweite Fläche (220) genannt, die durch eine Kontur (230) verbunden sind, wobei die zumindest eine Struktur in dem durchgehenden Hohlraum (130) so aufgenommen ist, dass die erste Fläche (210) und die Vorderseite (110) koplanar verlaufen, wobei der durchgehende Hohlraum (130) und/oder die zumindest eine Struktur (200) so angeordnet sind, dass sie um die Struktur (200) herum einen Umfangs- und Durchgangsraum (300) freilassen, der durch die Durchgangswand (140) und die Kontur (230) begrenzt ist;
wobei der Umfangsraum mit einem Dichtungsmaterial gefüllt ist, um die Strukturen (200) am Träger (100) zu halten;
wobei die Vorrichtung **dadurch gekennzeichnet ist, dass**
der Umfangsraum (300) eine radiale Erstreckungslänge aufweist, die von der Rückseite (120) zur Vorderseite (110) hin abnimmt, und dass das Dichtungsmaterial ein erstes Dichtungsmaterial und ein zweites Dichtungsmaterial enthält, das sich von dem ersten Material unterscheidet, wobei das erste Dichtungsmaterial einen Abschnitt des Umfangsraums (300), erster Abschnitt (300a) genannt, ausfüllt und das zweite Dichtungsmaterial einen weiteren Abschnitt des Umfangsraums (300), zweiter Abschnitt (300b) genannt, ausfüllt.

14. Vorrichtung nach Anspruch 13, wobei eine Schicht (500) aus dem ersten Dichtungsmaterial auch an der Durchgangswand (140) und der Kontur (230) im Bereich des zweiten Abschnitts (300b) ausgebildet ist.

15. Vorrichtung nach einem der Ansprüche 13 bis 14, wobei die radiale Erstreckungslänge von der Rückseite (120) zur Vorderseite (110) hin kontinuierlich variiert, wobei vorteilhaft die Durchgangswand (140) von der Rückseite (120) zur Vorderseite (110) eine konvergierende Neigung aufweist und/oder die Kontur (230) von der Rückseite (120) zur Vorderseite (110) eine divergierende Neigung aufweist.

16. Vorrichtung nach einem der Ansprüche 13 bis 15, wobei der erste Abschnitt (300a) eine konstante radiale Erstreckungslänge, erste Länge genannt, aufweist, wobei die erste Länge vorteilhaft weniger als 25 %, vorzugsweise weniger als 10 %, der radialen Erstreckungslänge im Bereich der Rückseite (120) beträgt.

17. Vorrichtung nach Anspruch 16, wobei der zweite Abschnitt (300b) eine konstante radiale Erstreckungslänge, zweite Länge genannt, aufweist.

## Claims

1. Method for integrating structures (200) in a support (100), the method comprising the following steps:
a) supplying a support (100) provided with two main faces designated, respectively, front face (110) and rear face (120), the support (100) comprising through cavities (130) each delimited by a wall designated through wall;
b) inserting into each of the through cavities (130) at least one structure (200), the at least one structure (200) being provided with two faces, designated respectively, first face (210) and second face (220) connected by a contour (230), the insertion of the at least one structure (200) being carried out such that the first face (210) and the front face (110) are coplanar, the through cavities (130) and/or the structures (200) being laid out to leave, around each of the structures (200), a peripheral through space delimited by the through wall and the contour (230);
c) filling the peripheral space (300) with a sealing material so as to maintain the structures (200) to the support (100);
the method being **characterised in that** the peripheral space (300) has a radial extension length which decreases from the rear face (120) to the front face (110) and **in that** the sealing material comprises a first sealing material and a second sealing material different from the first sealing material, step c) comprises the filling by the first sealing material of a section, designated first section (300a), of the peripheral space (300), then by the second sealing material of another section, designated second section (300b), of the peripheral space (300).

2. Method according to claim 1, wherein, for each of the peripheral space (300)s, a layer (500) comprising the first sealing material is also formed on the through wall and the contour (230) at the level of the second section (300b).

3. Method according to claim 1 or 2, wherein the first sealing material comprises at least one of the materials selected from: epoxy adhesive filled or not with silica grains, polyurethane, parylene, a siloxane, elastomer, silicone, acrylic, methacrylate, polypropylene, glass or metal.

4. Method according to one of the claims 1 to 3, wherein the second sealing material comprises at least one of the materials selected from: epoxy adhesive filled with silica grains, polyurethane, elastomer, silicone, acrylic, methacrylate, polypropylene and fusible glass.

5. Method according to one of the claims 1 to 4, wherein the radial extension length varies in a continuous manner from the rear face (120) to the front face (110), advantageously for each of the peripheral spaces (300), the cross wall (140) has an inclination converging from the rear side (120) to the front (110) and/or the contour (230) has a diverging tilt from the rear side (120) to the front (110).

6. Method according to one of the claims 1 to 5, wherein the radial extension length at the level of the first section (300a) is less than 50 % of the radial extension length at the level of the rear face (120).

7. Method according to one of the claims 1 to 4, wherein the first section (300a) has a constant radial extension length, designated first length, the first length being advantageously less than 25%, preferably less than 10%, to the radial extension length at the rear side (120).

8. Method according to one of the claims 1 to 7, wherein the second section (300b) extends, from the rear face (120), over a depth corresponding to at least half of the thickness of the support (100).

9. Method according to one of the claims 1 to 8wherein the radial extension length at the level of the front face (110) is comprised between 5 µm and 100 µm.

10. Method according to one of the claims 1 to 9, wherein the second sealing material has a Young's modulus comprised in an interval of +/- 20% of the Young's modulus of the support (100).

11. Method according to one of the claims 1 to 10, wherein each structure (200) comprises a first structure (200) and a second structure (200) each having a face coplanar with the front face (110).

12. Method according to one of the claims 1 to 11, wherein step b) is preceded by a step of assembly a1) of the front face (110) of the support (100) with a temporary face (410) of a temporary substrate.

13. Device comprising:
a) a support (100) provided with two main faces designated, respectively, front face (110) and rear face (120), the support (100) comprising a through cavity delimited by a wall designated through wall;
b) at least one structure (200), the at least one structure (200) being provided with two faces, designated respectively first face (210) and second face (220), connected by a contour, the at least one structure (200) being housed in the through cavity and such that the first face (210) and the front face (110) are coplanar, the through cavity and/or the at least one structure (200) being laid out to leave, around the structure (200), a peripheral through space delimited by the through wall and the contour (230);
the peripheral space (300) being filled with a sealing material so as to maintain the structures (200) to the support (100);
the device being **characterised in that** the peripheral space (300) has a radial extension length which decreases from the rear face (120) to the front face (110), and **in that** the sealing material comprises a first sealing material and a second sealing material different from the first material, the first sealing material filling a section, designated first section (300a), of the peripheral space (300), and the second sealing material filling another section, designated second section (300b), of the peripheral space (300).

14. Device according to claim 13, wherein a layer comprising the first sealing material is also formed on the through wall and the contour at the level of the second section (300b).

15. Device according to one of the claims 13 to 14, wherein the radial extension length varies in a continuous manner from the rear face (120) to the front face (110), advantageously the cross wall (140) has a converging tilt from the rear side (120) to the front (110) and/or the outline (230) has a diverging tilt from the rear side (120) to the front (110).

16. Device according to one of the claims 13 to 15, wherein the first section (300a) has a constant radial extension length, designated first length, the first length being advantageously less than 25%, preferably less than 10%, to the length of radial extension at the level of the rear face (120).

17. Device according to claim 16, wherein the second section (300b) has a constant radial extension length, designated second length.
